(19)

Europäisches
Patentamt
European
Patent Office
Office européen
des brevets

(11) **EP 2 492 830 A1**

(12) **EUROPEAN PATENT APPLICATION**
published in accordance with Art. 153(4) EPC

(43) Date of publication:
**29.08.2012 Bulletin 2012/35**

(21) Application number: **10824847.7**

(22) Date of filing: **14.10.2010**

(51) Int Cl.:
*G06F 19/00* (2011.01)     *G01W 1/00* (2006.01)

(86) International application number:
**PCT/JP2010/068022**

(87) International publication number:
**WO 2011/048998 (28.04.2011 Gazette 2011/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.10.2009 JP 2009241399**

(71) Applicant: **Mitsubishi Heavy Industries, Ltd.
Tokyo 108-8215 (JP)**

(72) Inventors:
• **OHBA, Ryoji
Tokyo 108-8215 (JP)**

• **OKABAYASHI, Kazuki
Tokyo 108-8215 (JP)**
• **HARA, Tomohiro
Tokyo 108-8215 (JP)**
• **YONEDA, Jiro
Tokyo 108-8215 (JP)**
• **NAGAYAMA, Yoshinori
Tokyo 108-8215 (JP)**

(74) Representative: **Delumeau, François Guy et al
Cabinet Beau de Loménie
158, rue de l'Université
75340 Paris Cedex 07 (FR)**

(54) **DIFFUSION STATE PREDICTION DEVICE, METHOD, AND PROGRAM**

(57)     Diffusion calculation is performed with a shorter processing time and superior precision. Provide are a calculation-grid determining unit (2) that determines a size of a calculation grid dividing a space in a region of interest ; a boundary-setting calculation unit (31) that reads out, from a building shape database (1), the building shape of a high-rise building, which is a building higher than a length of one side of the calculation grid, sets the building shape in a boundary condition, and performs the diffusion calculation for the region of interest; and a resistor calculation unit (32) that defines a plurality of low-rise buildings, which are buildings lower than or equal to the length of one side of the calculation grid, from the building shape database (1), as a resistor group, that reads out one or a plurality of calculation grids covering this resistor group as a low-rise calculation grid, that determines a resistance coefficient on the basis of the space occupancy of the resistor group in the low-rise calculation grid, and that performs a diffusion calculation for the region of interest.

FIG. 2

**Description**

{Technical Field}

The present invention relates to a diffusion-state prediction device, method, and program.

{Background Art}

In the event of the release of a harmful material due to an accident, an attack etc., there is a known diffusion-state prediction system in the related art that predicts the diffusion area and diffusion concentration of the harmful material and predicts regions that will be affected by the harmful material. In this diffusion-state prediction system, first, partial differential equations for analyzing atmospheric phenomena are calculated on the basis of atmospheric GPV (Grid Point Value) data or atmospheric measurement data a such as AMEDAS. Thus, atmospheric conditions (wind direction, wind speed, etc.) at a plurality of evaluation points are at fixed time intervals, over a calculation period from the time of occurrence of an accident for example external release of nuclear material) to a point a prescribed time in the future Then the diffusion state of the material released from the source of the accident is predicted on the basis of these atmospheric conditions.

{Citation List}

{Patent Literature}

{PTL 1} Japanese Unexamined Patent Application, Publication No. 2002-202383

{Non Patent Literature}

{NPL 1} Architectural Institute of Japan, "Guidebook for Practical Applications of CFD to Pedestrian Wind Environment around Buildings" (Showa Joho Process Co., Ltd., 20 July 2007), pp. 49-51.

{Summary of Invention}

{Technical Problem}

For example, Patent Literature 1 cited above discloses a technique for obtaining airflow elements in an area of several km by the nesting method, which is a method of performing the computation by finely dividing the calculation grid for a particular region of interest inside a larger region, roughly dividing the calculation grid for the region outside it, and then calculating the airflow elements at intervals of several m in the vicinity of buildings, by using a fluid dynamics model (CFD model). However, a problem with the method in Patent Literature 1 above is that, although the airflow elements in the vicinity of buildings can be calculated with good precision, because the number of calculation grids is large, a huge amount of time is needed; for example, several days or more are needed for the diffusion calculation even if a high-speed parallel computer is used.

Non-Patent Literature 1 cited above recently disclosed a method (Canopy model) for performing a diffusion calculation in which solid objects and fluids are considered as existing in an intermingled fashion in the calculation grid, and by defining solid objects as resistors and approximating building shapes with air-resistance coefficients. However, there are some problems with the method in Non-Patent Literature 1 above: although it is possible to reduce the time taken for the calculation compared with the case where the diffusion calculation is performed with rigorously modeled building shapes, a plurality of complex building shapes cannot be considered, it is difficult to take account of the influence of vortices, reverse-flow phenomena, etc. in the vicinity of buildings, and the diffusion calculation cannot be performed with good precision.

The present invention has been conceived to solve the problems described above, and an object thereof is to provide an atmospheric-conditions prediction device, method, and program that can perform a diffusion calculation with a shorter processing time and with superior precision.

{Solution to Problem}

In order to solve the problems described above, the present invention employs the following.
A first aspect of the present invention is a diffusion-state prediction device for predicting atmospheric conditions in a region of interest containing a point of interest, including a calculation-grid determining unit that determines a size of a calculation grid dividing a space in the region of interest; a boundary-setting calculation unit that reads out, from among building shapes for the region of interest, the building shape of a high-rise building, which is a building higher than a length of one side of the calculation grid, sets the building shape in a boundary condition, and performs the diffusion calculation for the region of interest; and a resistor calculation unit that defines a plurality of low-rise buildings, which are buildings lower than or equal to the length of one side of the calculation grid, from among the building shapes for the region of interest, as a resistor group, that reads out one or a plurality of calculation grids covering this resistor group as a low-rise calculation grid, that determines a resistance coefficient on the basis of a space occupancy of the resistor group in the low-rise calculation grid, and that performs a diffusion calculation for the region of interest.

With such a configuration, it is decided whether the building shape in the region of interest is a high-rise building or a low-rise building according to whether the building shape in the region of interest is larger than the length of one side of the calculation grid determined by dividing the space in the region of interest into a grid. The building shape of a building judged as being a high-rise building is set as the boundary conditions, and the diffusion calculation is performed for the region of interest. Also, with a plurality of low-rise buildings serving as a resistor group, a resistance coefficient is determined on the basis of the space occupancy of the resistor group in the low-rise calculation grid read out from one or a plurality of calculation grids covering the resistor group, and the diffusion calculation is performed for the region of interest. Buildings include high-rise buildings and low-rise buildings.

Accordingly, for high-rise buildings which have a large influence on the airflows, because the building shape is set as the boundary conditions, it is possible to perform a rigorous numerical computation of the atmospheric diffusion phenomena. In addition, for the low-rise buildings, which have a smaller influence on the airflows compared with high-rise buildings, because the diffusion calculation is performed by approximating them as a collection of resistors in the low-rise calculation grid, it is possible to reduce the time taken for the diffusion calculation in regions containing low-rise buildings compared with the case where the building shapes are given as the boundary conditions. The method of approximating them as a collection of resistors in the calculation grid is, for example, the Canopy model.

A second aspect of the present invention is a diffusion-state prediction device for predicting atmospheric conditions in a region of interest containing a point of interest, including a calculation-grid determining unit that determines a size of a calculation grid dividing a space in the region of interest; and a resistor calculation unit that performs a diffusion calculation for the region of interest on the basis of a resistance coefficient determined according to a space occupancy in the calculation grid, wherein the resistor calculation unit, from among building shapes for the region of interest, defines a plurality of low-rise buildings, which are buildings lower than or equal to a length of one side of the calculation grid, as a resistor group, reads out one or a plurality of calculation grids covering this resistor group as a low-rise calculation grid, determines a resistance coefficient on the basis of the space occupancy of the resistor group in the low-rise calculation grid, and performs a diffusion calculation for the region of interest; and reads out a building shape of a high-rise building, which is a building higher than the length of one side of the calculation grid, determines a resistance coefficient with the space occupancy in the building shape set at 100 percent, and performs the diffusion calculation for the region of interest.

with such a configuration, it is decided whether a building is a high-rise building or a low-rise building according to whether it is larger than the length of one side of the calculation grid determined by dividing the space in the region of interest into a grid. For buildings that are judged as being high-rise buildings, the diffusion calculation for the region of interest is performed on the basis of the determined resistance coefficient, with the space occupancy in the building shape set to 100 percent. For buildings that are judged as being low-rise buildings, the resistance coefficient is determined on the basis of the space occupancy of the resistor group in the low-rise calculation grid, and the diffusion calculation is performed. Thus, buildings are categorized as high-rise buildings or low-rise buildings according to the height of the calculation grid, and the diffusion calculation is performed with the respective resistance coefficients for high-rise and low-rise; therefore, the diffusion calculation can be performed with the ratio of resistances adjusted according to high-rise buildings and low-rise buildings.

When the diffusion calculation is performed with the resistance coefficient determined for the space occupancy of the high-rise building set to 100 percent, the calculation grid can be made larger compared with a case where the diffusion calculation is performed with the building shape set as the boundary conditions, and therefore, it is possible to reduce the time taken for the computation. For example, in the case where the calculation grid is on the order of a 50 meters, the computation time can be made about 1/20th compared with the case where the calculation grid is on the order of a few meters. The method involving the building shapes of high-rise buildings or approximating the low-rise buildings as resistors is, for example, the Canopy model.

The calculation grid determining unit in the above-described diffusion state prediction device may determine a height of the calculation grid on the basis of a resolution required for a phenomenon to be calculated.

The height of the calculation grid required for the resolution of the phenomenon to be computed (for example, wind speed distribution, gas concentration distribution, etc.) is determined according to the application. For example, when a concentration distribution with a 10-meter calculation grid (mesh) is required, the calculation grid is set to 10 meters, and the diffusion calculation is performed with buildings larger than 10 meters serving as high-rise buildings, and building lower than this serving as low-rise buildings. By setting the calculation grid in this way, it is possible to vary the time taken for the diffusion calculation depending on the phenomenon to be computed, and the time taken for the calculation can be reduced. Also, for example, the size of the calculation grid may be set to the height of the smallest calculation grid, or it may be set two times larger or three times larger than the height of the smallest calculation grid, and so on.

The above-described diffusion state prediction device may further include an information acquiring unit that acquires a threshold value of time taken to predict the atmospheric conditions, wherein the calculation-grid determining unit may determine the calculation grid on the basis of the size of the region of interest and the threshold value acquired by the information acquiring unit.

Accordingly, because the calculation grid is determined according to a set time limit, it is possible to complete the prediction of the atmospheric conditions within the time limit.

The resistor calculation unit in the above-described diffusion state prediction device may have a computational expression containing an external force term that approximates the building shape using a resistance coefficient which indicates a proportion occupied by the building in the calculation grid, and the external force term may be set so that a value of the resistor indicating the high-rise building is larger than a value of the resistor group indicating the low-rise buildings.

By varying the external force term in the calculation formula in this way, it is possible to readily change the sizes of the resistors for the high-rise buildings and the low-rise buildings.

In the case where the building in the region of interest in the above-described diffusion state prediction device has a complex shape including a shape that does not match an outline of the calculation grid, a calculation-grid decision unit for deciding between the calculation grid that is entirely contained inside the building and the calculation grid that is partially contained therein, from among the calculation grids covering the building with the complex shape; and in the case where the calculation grid is decided as being partially contained, from among the calculation grids covering the building with the complex shape, the resistance coefficient of the building with the complex shape is determined on the basis of the space occupancy of the building in the calculation grid, and the diffusion calculation is performed.

Thus, it is possible to approximately calculate buildings in a simple manner, even for complex building shapes.

A third aspect of the present invention is a diffusion-state prediction method for predicting atmospheric conditions in a region of interest containing a point of interest, including a calculation-grid determining stage of determining a size of a calculation grid dividing a space in the region of interest; a boundary-setting calculation stage of reading out, from among building shapes for the region of interest, a building shape of a high-rise building, which is a building higher than a length of one side of the calculation grid, setting the building shape in a boundary condition, and performing a diffusion calculation for the region of interest; and a resistor calculating stage of defining, from among the building shapes for the region of interest, a plurality of low-rise buildings, which are buildings lower than or equal to the length of one side of the calculation grid, as a resistor group, reading out one or a plurality of calculation grids covering this resistor group as a low-rise calculation grid, determining a resistance coefficient on the basis of a space occupancy of this resistor group in the low-rise calculation grid, and performing the diffusion calculation for the region of interest.

A fourth aspect of the present invention is a diffusion-state prediction program for predicting atmospheric conditions in a region of interest containing a point of interest, the diffusion-state prediction program causing a computer to execute a calculation-grid determining processing for determining a size of a calculation grid dividing a space in the region of interest; a boundary-setting calculation processing for reading out, from among building shapes for the region of interest, a building shape of a high-rise building, which is a building higher than a length of one side of the calculation grid, setting the building shape in a boundary condition, and performing a diffusion calculation for the region of interest; and a resistor calculation processing for defining, from among the building shapes for the region of interest, a plurality of low-rise buildings, which are buildings lower than or equal to the length of one side of the calculation grid, as a resistor group, reading out one or a plurality of calculation grids covering this resistor group as a low-rise calculation grid, determining a resistance coefficient on the basis of a space occupancy of the resistor group in the low-rise calculation grid, and performing the diffusion calculation for the region of interest.

A fifth aspect of the present invention is a diffusion-state prediction method for predicting atmospheric conditions in a region of interest containing a point of interest, including a calculation-grid determining stage of dividing a space in the region of interest into a grid and determining a size of a calculation grid; and a resistor calculating stage of performing a diffusion calculation for the region of interest on the basis of a resistance coefficient determined according to a space occupancy in the calculation grid, wherein the resistor calculation stage, from among building shapes for the region of interest, defines a plurality of low-rise buildings, which are buildings lower than or equal to a length of one side of the calculation grid, as a resistor group, reads out one or a plurality of calculation grids covering this resistor group as a low-rise calculation grid, determines a resistance coefficient on the basis of the space occupancy of the resistor group in the low-rise calculation grid, and performs a diffusion calculation for the region of interest; and reads out a building shape of a high-rise building, which is a building higher than the length of one side of the calculation grid, determines a resistance coefficient with the space occupancy in the building shape set at 100 percent, and performs the diffusion calculation for the region of interest.

A sixth aspect of the present invention is a diffusion-state prediction program for predicting atmospheric conditions in a region of interest containing a point of interest, the diffusion-state prediction program causing a computer to execute a calculation-grid determining processing for determining a size of a calculation grid dividing a space in the region of interest; and a resistor calculating processing for performing a diffusion calculation for the region of interest on the basis of a resistance coefficient determined according to a space occupancy in the calculation grid, wherein the resistor calculation processing, from among building shapes for the region of interest, defines a plurality of low-rise buildings, which are buildings lower than or equal to a length of one side of the calculation grid, as a resistor group, reads out one or a plurality of calculation grids covering this resistor group as a low-rise calculation grid, determines a resistance coefficient, on the basis of the space occupancy of the resistor group in the low-rise calculation grid, and performs the diffusion calculation for the region of interest; reads out a building shape of a high-rise building, which is a building higher than the length of one side of the calculation grid, determines a resistance coefficient with the space occupancy in the building shape set at 100 percent, and performs the diffusion calculation for the region of interest.

{Advantageous Effects of Invention}

The present invention affords an advantage in that it enables a diffusion calculation with a shorter processing time and superior precision.

{Brief Description of Drawings}

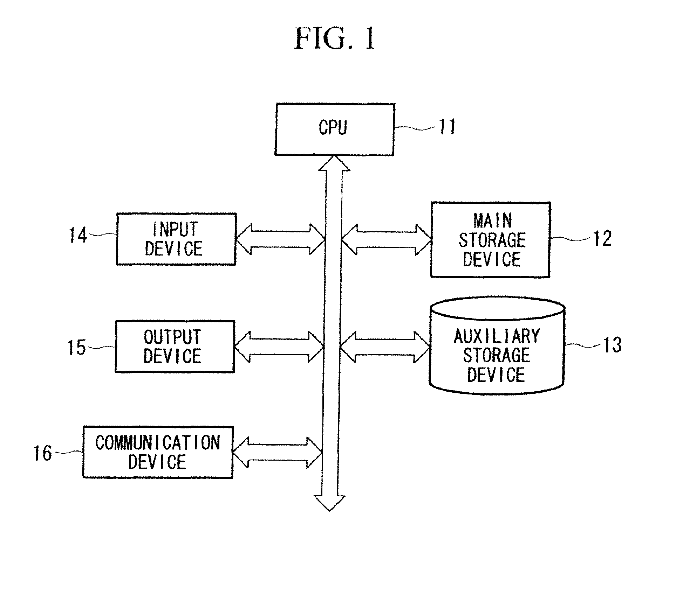

{Fig. 1} Fig. 1 is a block diagram showing, in outline, the configuration of a diffusion-state prediction device according to a first embodiment of the present invention.

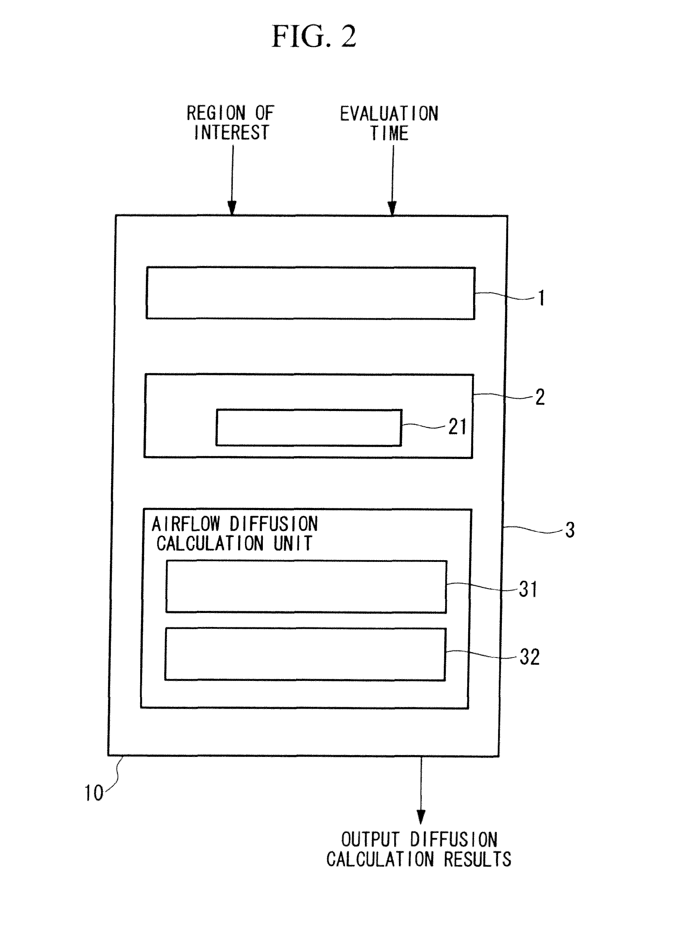

{Fig. 2} Fig. 2 is a functional block diagram of the diffusion-state prediction device according to the first embodiment of the present invention.

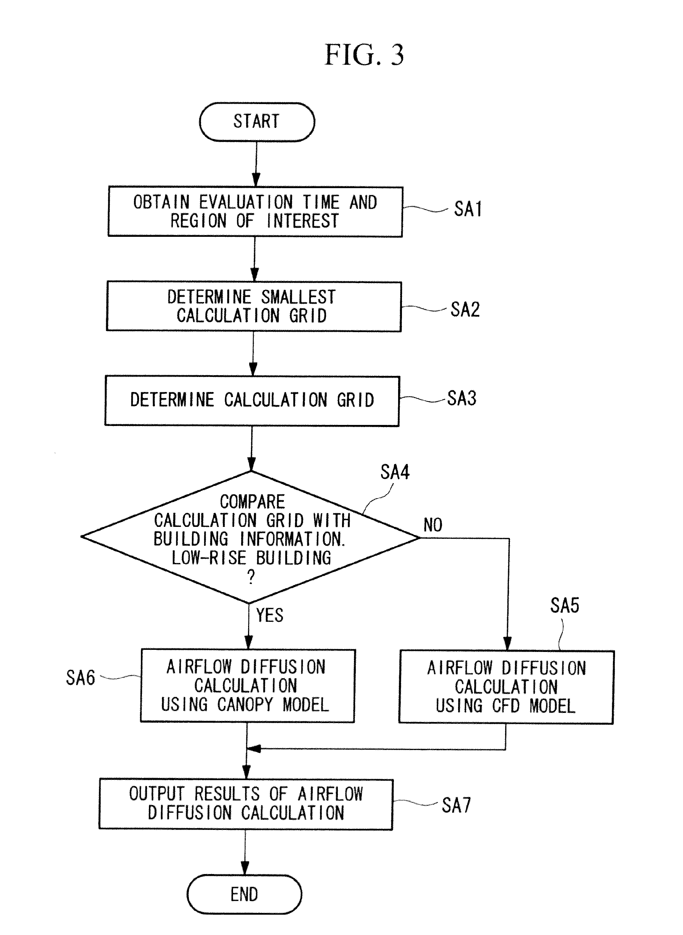

{Fig. 3} Fig. 3 is the operating flow of the diffusion-state prediction device according to the first embodiment of the present invention.

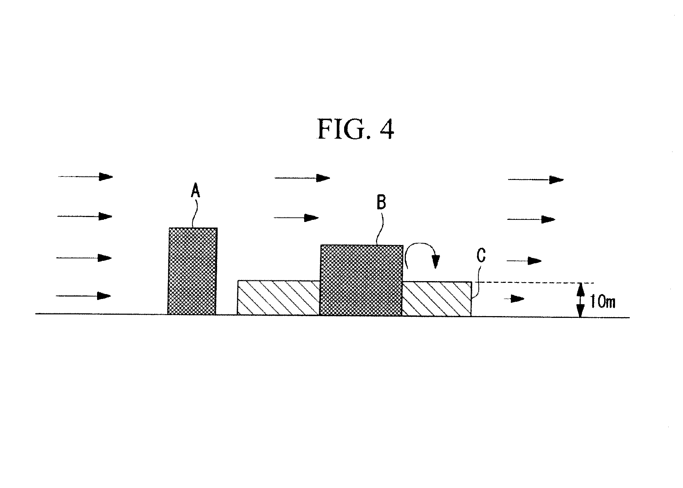

{Fig. 4} Fig. 4 is a diagram in which buildings A and B and a resistor group C are viewed in perpendicular cross section.

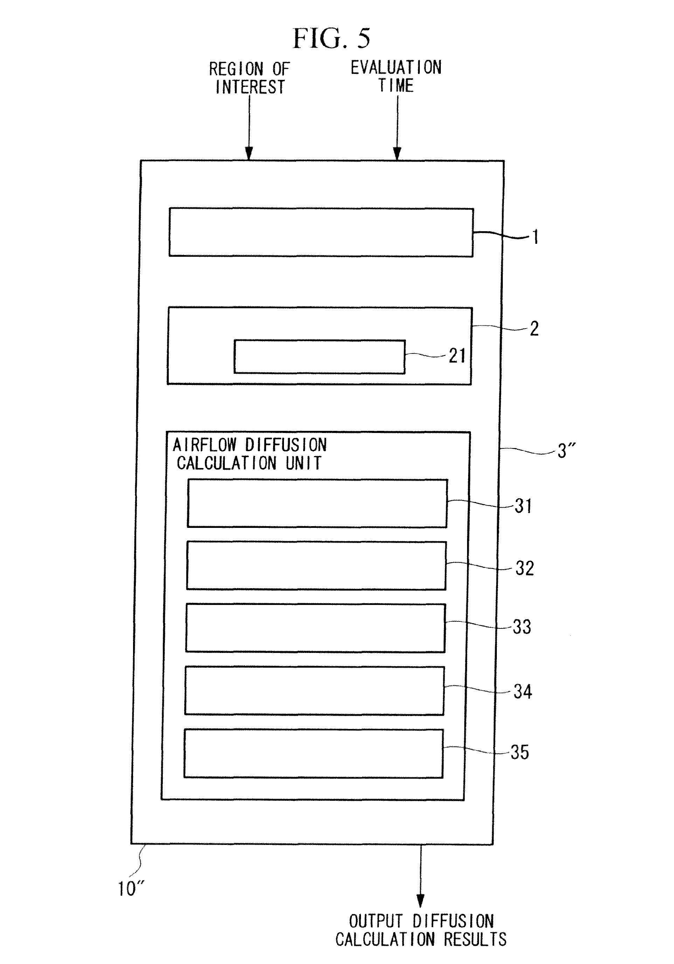

{Fig. 5} Fig. 5 is a functional block diagram of a diffusion-state prediction device according to a third embodiment of the present invention.

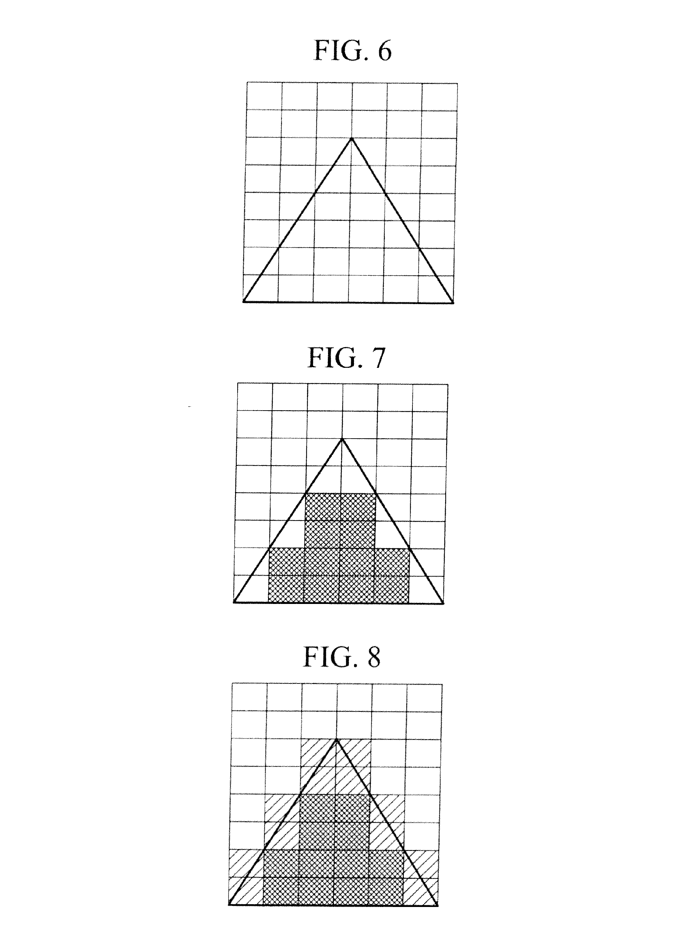

{Fig. 6} Fig. 6 is a diagram for explaining the computation method in an airflow diffusion calculation unit according to the third embodiment of the present invention.

{Fig. 7} Fig. 7 is a diagram continuing the explanation of the computation method in the airflow diffusion calculation unit according to the third embodiment of the present invention.

(Fig. 8) Fig. 8 is a diagram continuing the explanation of the computation method in the airflow diffusion calculation unit according to the third embodiment of the present invention.

{Description of Embodiments}

An embodiment of a diffusion-state prediction device, method, and program according to the present invention will be described below with reference to the drawings.

First Embodiment

Fig. 1 is a block diagram showing, in outline, the configuration of a diffusion-state prediction device according to this embodiment. The diffusion-state prediction device according to this embodiment is a device that predicts the atmospheric conditions in a region of interest, which is a prescribed region containing a point of interest where a nuclear power plant or the like is installed, and, by using the predicted atmospheric conditions, predicts the diffusion state of a diffused material released from the point of interest.

As shown in Fig. 1, the diffusion-state prediction device according to this embodiment is a computer system (calculating device system) and is formed of a CPU (central processing unit) 11, a main storage device 12 such as a RAM (Random Access Memory), an auxiliary storage device 13, an input device 14 such as a keyboard or mouse, an output device 15 such as a display or printer, a communication device 16 that sends and receives information by performing communication with an external device, and so forth.

The auxiliary storage device 13 is a computer-readable storage medium, for example, a magnetic disk, a magnetooptical disk, a CD-ROM, a DVD-ROM, a semiconductor memory, etc. Various programs (for example, a diffusion-state prediction program) are stored in this auxiliary storage device 13, and the CPU 11 implements various types of processing by reading out the programs from the auxiliary storage device 13 into the main storage device 12 and executing them.

Fig. 2 is a functional block diagram showing, in expanded fashion, the functions provided in a diffusion-state prediction device 10. As shown in Fig. 2, the diffusion-state prediction device 10 includes a building shape database 1, a calculation-grid determining unit 2, and an airflow diffusion calculation unit 3.

Next, details of the processing executed in each unit provided in the above-described diffusion-state prediction device 10 will be described with reference to Fig. 2. The various types of processing, described later, realized by each unit shown in Fig. 2 are realized by the CPU 11 reading out the diffusion-state prediction program stored in the auxiliary storage device 13 into the main storage device 12 and executing the program.

The building shape database 1 stores maps having building information, which contains details of buildings, such as building shape and building height data, and building information for a desired region is supplied from this building shape database.

In this embodiment, the building shape database 1 is described as being included in the diffusion-state prediction device 10; however, it is not limited thereto. For example, building shapes may be stored in an external database etc. connected via a network so as to enable communication with the diffusion-state prediction device 10, and the building shapes may be obtained from this external database etc.

The calculation-grid determining unit 2 determines the length of one side of a calculation grid that divides the space inside the region of interest. The calculation-grid determining unit 2 determines the length (size) of one side of the calculation grid on the basis of the resolution required for the phenomenon to be computed. The phenomenon to be computed is, for example, wind speed distribution, gas concentration distribution, etc. For example, if the concentration distribution with a 10-meter calculation grid (calculation mesh) is required, the size of the calculation grid is determined to be 10 meters. By setting the size of the calculation grid according to the phenomenon to be computed in this way, the time taken for the diffusion calculation can be appropriately modified, and therefore, it is possible to reduce wasteful calculation time.

More specifically, the calculation-grid determining unit 2 includes an information acquiring unit 21. The information acquiring unit 21 obtains a threshold value of the evaluation time taken to predict the atmospheric conditions and the size of the region of interest. Specifically, the information acquiring unit 21 obtains information on the threshold value of the evaluation time taken to predict the diffusion state and region information about the region of interest containing the point of interest, via the input device 14 in Fig. 1.

The calculation-grid determining unit 2 determines the size of the region of interest obtained by the information acquiring unit 21 and the size of the smallest calculation grid (smallest calculation mesh) based on the threshold value of the evaluation time, and also determines the size of the calculation grid. In this embodiment, it is described that the smallest calculation grid is used as the size of the calculation grid; however, it is not limited thereto. For example, it may be two times, three times, etc. larger than the smallest calculation grid.

The airflow diffusion calculation unit 3 performs an airflow calculation and a diffusion calculation on the basis of the calculation grid determined by the calculation-grid determining unit 2. Specifically, the airflow diffusion calculation unit 3 is provided with a boundary-setting calculation unit 31 and a resistor calculation unit 32.

The boundary-setting calculation unit 31 reads out a building shape of a high-rise building, which is a building that is higher than the length of one side of the calculation grid, from the building shape database 1, sets the building shape in the boundary conditions, and performs the diffusion calculation for the region of interest. Specifically, for a high-rise building that strongly influences the airflows, the boundary-setting calculation unit 31 models, as accurately as possible, the building shape based on fluid dynamics techniques (CFD model) for rigorous numerical calculation of the airflow and diffusion phenomena, to perform the diffusion calculation for the region of interest.

The resistor calculation unit 32 reads out, from the building shape database 1, a plurality of low-rise buildings, which are buildings lower than or equal to the length of one side of the calculation grid, as a resistor group, reads out one or a plurality of calculation grids covering this resistor group as a low-rise calculation grid(s), determines a resistance coefficient on the basis of the space occupancy of the resistor group in the low-rise calculation grid(s), and performs the diffusion calculation for the region of interest. Specifically, for low-rise buildings that have a smaller influence on the airflows compared with a high-rise building, the resistor calculation unit 32 performs the diffusion calculation for the region of interest by using a technique (Canopy Model) for modeling buildings approximately as a resistor group.

In the Canopy Model, it is known that a computational expression can be created by adding an external force term representing the force exerted on a fluid due to the resistance of objects (see Patent Literature 1). For example, an external force term $F_i$ is shown in Equation (1) below. Here, $C_d$ is a resistance coefficient corresponding to the shape, surface area density, and volume density of the objects, and $u_i$ is the wind speed.

{FORMULA 1}

$$Fi = \frac{1}{2} C_d\, u_i \left| u_i \right| \qquad (1)$$

In this embodiment, this resistance coefficient Cd is, for example, a coefficient that varies according to the ratio (space occupancy) occupied by the resistor group (the plurality of low-rise buildings) in the low-rise calculation grid. Specifically, the resistor calculation unit 32 applies a plurality of values of the resistance coefficient Cd of the low-rise buildings using the flow speed distribution etc. behind an object (for example, a building) in the numerical computation so as to match the wind speed measurements (for example, the wind speed distribution) from a wind-tunnel test modeling the low-rise buildings, and selects an appropriate value from the results thereof.

Next, the operation of the diffusion-state prediction device 10 according to this embodiment will be described using Fig. 3 and Fig. 4. Fig. 4 shows a diagram of buildings A and B and a resistor group C in perpendicular sectional view. First, when the diffused material is released at the point of interest, region information on the region of interest, containing the point of interest, and threshold information of the evaluation time for the diffusion calculation are input via the input device 14 and are acquired by the information acquiring unit 21 in the calculation-grid determining unit 2 (step SA1 in Fig. 3). Based on the region information and the threshold information of the evaluation time acquired by the information acquiring unit 21, the size of the smallest calculation grid (for example, 10 meters) is determined by the calculation-grid determining unit 2 (step SA2 in Fig. 3), and then, based on the size of the smallest calculation grid, the calculation grid (for example, 10 meters, which is a factor of one times the size of the smallest calculation grid) is determined (Step SA3 in Fig. 3).

The determined calculation grid and the building information stored in the building shape database 1 are compared (Step SA4 in Fig. 3). If, as a result of the comparison, the building shapes of the high-rise buildings (for example, buildings A and B) that are higher than the height of the calculation grid are read out from the building shape database 1 and are input to the boundary-setting calculation unit 31, the building shapes of the high-rise buildings are set as the boundary conditions, and the airflow diffusion calculation is performed with the wind speed inside the buildings set to zero (step SA5 in Fig. 3). Also, if, as a result of the comparison, the low-rise buildings that are equal to or lower than the height of the calculation grid serve as the resistor group (for example, resistor group C) in the low-rise calculation grid, and the low-rise calculation grid that covers this resistor group C is read out, the airflow diffusion calculation is performed on the basis of the resistance coefficient determined on the basis of the space occupancy of the resistor group C in the low-rise calculation grid (step SA6 in Fig. 3).

The calculation results of the airflow diffusion calculation computed by the boundary-setting calculation unit 31 and the resistor calculation unit 32 are provided to the user via the output device 15 (step SA7 in Fig. 3).

Because the atmospheric diffusion phenomenon is numerically calculated by modeling, as closely as possible the building shapes of the high-rise buildings A and B in this way, eddies etc. behind the high-rise buildings A and B are modeled, and the numerical computation is rigorously performed. For the low-rise buildings, numerical computation is performed by approximately modeling them as a collection of resistors, serving as the resistor group C. Accordingly, compared with the conventional case where calculation is performed with a calculation grid on the order of a few meters, because the low-rise buildings are treated as a resistor group, it is possible to increase the calculation grid, and therefore it is possible to reduce the time required for the calculation.

As described above, with the diffusion-state prediction device 10, method, and program according to the present invention, it is decided whether a building in the building shape database 1 is a high-rise building or a low-rise building depending on whether it is larger than the length of one side of the calculation grid determined by dividing the space in a region of interest in the form of a grid, and if it is determined as being a high-rise building, the building shape of the high-rise building is set as the boundary conditions in the boundary-setting calculation unit 31, and the diffusion calculation is performed for the region of interest. The plurality of low-rise buildings are defined as a resistor group in the resistor calculation unit 32, a resistance coefficient is determined on the basis of the space occupancy of the resistor group in the low-rise calculation grid read out from the calculation grid covering the resistor group, and the diffusion calculation is performed for the region of interest on the basis of the resistance coefficient. Thus, for high-rise buildings which have a strong influence on the airflows, rigorous numerical computation of the atmospheric diffusion phenomenon is performed, whereas for low-rise buildings which have a small influence on the airflows as compared with the high-rise buildings, the diffusion calculation is performed by approximating them as a collection of resistors in the low-rise calculation grid. Accordingly, the time required for the diffusion calculation of the region containing the low-rise buildings can be reduced compared with the case where the building shapes serve as the boundary conditions. Because the size of the calculation grid is determined on the basis of the size of the region of interest and a threshold value of the computation time, diffusion calculation for a prescribed region can be accomplished within a time limit.

Although the case where the wind speed distribution is calculated has been described as an example in this embodiment, the calculation is not limited thereto. For example, it may be applied to calculation of concentration distribution. In the case of concentration, one condition is that there be no concentration gradient between the inside and the outside of the buildings.

In this embodiment, the diffusion calculation around the high-rise buildings by the boundary-setting calculation unit 31 and the diffusion calculation around the low-rise buildings by the resistor-calculation unit 32 are described as being performed simultaneously; however, the calculation method is not limited thereto. For example, either one of them may be calculated first and then the remaining one may be calculated afterwards, or the results of the one calculated first may be used to calculate the other one.

Second Embodiment

Next, a second embodiment of the present invention will be described.
The difference between the diffusion-state prediction device of this embodiment and that of the first embodiment is that the resistor calculation unit 32 includes a first resistor calculation unit (not shown) and a second resistor calculation unit (not shown). In the following description of the diffusion-state prediction device of this embodiment, a description of commonalities with the first embodiment will be omitted, and mainly the differences will be described.

The resistor calculation unit 32 performs the diffusion calculation for the region of interest on the basis of a resistance coefficient determined from the space occupancy in the calculation grid. Specifically, the resistor calculation unit 32 includes the first resistor calculation unit (not shown) and the second resistor calculation unit (not shown).
The first resistor calculation unit defines low-rise buildings, which are buildings lower than or equal to the length of one side of the calculation grid from the building shape database 1, as a resistor group, reads out one or a plurality of calculation grids covering this resistor group as a low-rise calculation grid(s), determines the resistance coefficient on the basis of the space occupancy of the resistor group in the low-rise calculation grid, and performs the diffusion calculation for the region of interest.
The second resistor calculation unit reads out, from the building shape database 1, the building shape of a high-rise building, which is a building higher than the length of one side of the calculation grid, determines the resistance coefficient, with the space occupancy in the read building shape defined as 100 percent, and performs the diffusion calculation for the region of interest on the basis of this resistance coefficient.

As described above, in the technique for approximately modeling a building as a resistor (Canopy model), the diffusion calculation is performed using a calculation formula in which an external force term is added, as shown in Equation (1) above. In this embodiment, buildings are categorized as low-rise or high-rise depending on the calculation grid, and by making the external force terms applied to each one different, the diffusion calculation is performed for states in which the forces received by the buildings differ, according to the low-rise building case or the high-rise building case.
The external force term set in the second resistor calculation unit is larger than the external force term set in the first resistor calculation unit. In other words, the resistance coefficient $Cd_2$ applied in the second resistor calculation unit is larger than the resistance coefficient $Cd_1$ applied in the first resistor calculation unit. This is because the influence on the airflows from a high-rise building is larger than that from a low-rise building, and because the high-rise building serves as the entire resistor. In this embodiment, the resistance coefficient in the second resistor calculation unit is calculated with the space occupancy set at 100 percent, thereby being set larger than the resistance coefficient in the first resistor calculation unit.

As has been described above, with the diffusion-state prediction device, method, and program according to this embodiment, the diffusion calculation is performed with the high-rise building modeled as a resistor and the low-rise buildings modeled as a resistor group in respective calculation grids. Accordingly, the time taken for the diffusion calculation can be reduced compared with the case where the diffusion calculation is performed by using the CFD model with the high-rise building serving as the boundary conditions. Also, because the building shapes of the high-rise buildings are read out and the diffusion calculation is performed with the high-rise buildings serving as individual resistors, eddies and reverse flows behind the high-rise buildings can be modeled, and it is possible to obtain diffusion calculation results with high precision compared with the case where diffusion calculation is performed with the all-heights Canopy model, which does not distinguish between high-rise and low-rise.

Third Embodiment

Next, a third embodiment of the present invention will be described using Figs. 5 to 8.
The difference between a diffusion-state prediction device 10'' of this embodiment and the first second embodiments is that, in the case where the building shape is a complex shape including a shape that does not match the outline of the calculation grid, it is decided whether the calculation grid is a calculation grid entirely contained inside a building or a calculation grid partially contained therein, and an airflow diffusion calculation unit 3'' that determines the resistance coefficient according to the result of this decision and performs the diffusion calculation is provided. In the following description of the diffusion-state prediction device of this embodiment, a description of commonalities with the first and second embodiments will be omitted, and mainly the differences will be described.
Specifically, as shown in Fig. 5, the airflow diffusion calculation unit 3'' includes a calculation-grid decision unit 33, a partial calculation unit 34, and a complete calculation unit 35.
The calculation-grid decision unit 33 decides between a calculation grid that is entirely contained inside a building and a calculation grid that is partially contained therein, from among calculation grids that cover buildings with complex shapes, outputs information about the calculation grid that is entirely contained inside the building to the complete calculation unit 35, and outputs information about the calculation grid that is partially contained therein to the partial calculation unit 34.
The partial calculation unit 34 determines the resistance coefficient on the basis of the space occupancy of the building in the calculation grid decided as being the calculation grid that is partially contained, from among the calculation grids covering buildings with complex shapes, and performs the diffusion calculation for the region of interest.
The complete calculation unit 35 determines the resistance coefficient, with a space occupancy of 100 percent for the building in the calculation grid that is entirely contained inside the building, from among the calculation grids covering buildings with complex shapes, and performs the diffusion calculation. The external force term in the complete calculation unit 35, shown in Equation (1) above, is set larger than the external force term set in the partial calculation unit 34. In other words, the complete calculation unit 35 sets a resistance coefficient larger than the resistance coefficient that is set in the partial calculation unit 34.
For example, in the case of a complex shape like that shown in Fig. 6, this complex shape is compared with each of the calculation grids by the calculation grid decision unit 33, which decides between the calculation grid that is entirely contained inside the building and the calculation grid that is partially contained therein. As a result of the decision, as shown in Fig. 7, of these calculation grids, the calculation grid contained inside the complex shape (the dark-gray calculation grid in Fig. 7) is output to the complete calculation unit 35, and the diffusion calculation is performed in the complete calculation unit 35. When the result of the decision is the calculation grid partially containing the building (the light-gray (the region indicate by inclined lines) calculation grid in Fig. 8) (the case including both the inside and the outside of the complex shape), the calculation grid is output to the partial calculation unit 34, and the diffusion calculation is performed in the partial calculation unit 34.
As has been described above, with the diffusion-state prediction device 10'', method, and program according to this embodiment, the resistance coefficient is changed according to whether the calculation grid is entirely contained inside the building or is partially contained therein, and the diffusion calculation is performed for the region of interest. Accordingly, it is possible to perform the diffusion calculation for part of a complex building shape, and the time required for the diffusion calculation can be reduced.

{Reference Signs List}

| | |
|---|---|
| 1 | building shape database |
| 2 | calculation-grid determining unit |
| 3, 3'' | airflow diffusion calculation unit |
| 10, 10'' | diffusion-state prediction device |
| 21 | information acquiring unit |
| 31 | boundary-setting calculation unit |
| 32 | resistor calculation unit |
| 33 | calculation-grid decision unit |
| 34 | partial calculation unit |
| 35 | complete calculation unit |

**Claims**

1. A diffusion-state prediction device for predicting atmospheric conditions in a region of interest containing a point of interest, comprising:

   a calculation-grid determining unit that determines a size of a calculation grid dividing a space in the region of interest;

   a boundary-setting calculation unit that reads out, from among building shapes for the region of interest, the building shape of a high-rise building, which is a building higher than a length of one side of the calculation grid, sets the building shape in a boundary condition, and performs a diffusion calculation for the region of interest; and

   a resistor calculation unit that defines a plurality of low-rise buildings, which are buildings lower than or equal to the length of one side of the calculation grid, from among the building shapes for the region of interest, as a resistor group, that reads out one or a plurality of calculation grids covering this resistor group as a low-rise calculation grid, that determines a resistance coefficient on the basis of a space occupancy of the resistor group in the low-rise calculation grid, and that performs a diffusion calculation for the region of interest.

2. A diffusion-state prediction device for predicting atmospheric conditions in a region of interest containing a point of interest, comprising:

   a calculation-grid determining unit that determines a size of a calculation grid dividing a space in the region of interest; and

   a resistor calculation unit that performs a diffusion calculation for the region of interest on the basis of a resistance coefficient determined according to a space occupancy in the calculation grid,

   wherein the resistor calculation unit, from among building shapes for the region of interest,

   defines a plurality of low-rise buildings, which are buildings lower than or equal to the length of one side of the calculation grid, as a resistor group, reads out one or a plurality of calculation grids covering this resistor group as a low-rise calculation grid, determines a resistance coefficient on the basis of the space occupancy of the resistor group in the low-rise calculation grid, and performs a diffusion calculation for the region of interest; and reads out a building shape of a high-rise building, which is a building higher than the length of one side of the calculation grid, determines a resistance coefficient with the space occupancy in the building shape set at 100 percent, and performs the diffusion calculation for the region of interest.

3. A diffusion-state prediction device according to Claim 1 or Claim 2, wherein the calculation grid determining unit determines a width of the calculation grid on the basis of a resolution required for a phenomenon to be calculated.

4. A diffusion-state prediction device according to one of Claims 1 to 3, further comprising:

   an information acquiring unit that acquires a threshold value of time taken to predict the atmospheric conditions, wherein the calculation-grid determining unit determines the calculation grid on the basis of the size of the region of interest and the threshold value acquired by the information acquiring unit.

5. A diffusion-state prediction device according to one of Claims 2 to 4, wherein the resistor calculation unit has a computational expression containing an external force term that approximates the building shape using a resistance coefficient which indicates a proportion occupied by the building in the calculation grid, and the external force term is set so that a value of the resistor indicating the high-rise building is larger than a value of the resistor group indicating the low-rise buildings.

6. A diffusion-state prediction device according to one of Claims 1 to 5, further comprising:

   in the case where the building in the region of interest has a complex shape including a shape that does not match an outline of the calculation grid,

   a calculation-grid decision unit for deciding between the calculation grid that is entirely contained inside the building and the calculation grid that is partially contained therein, from among the calculation grids covering the building with the complex shape; and

   a partial calculation unit that determines the resistance coefficient of the building with the complex shape on the basis of the space occupancy of the building in the calculation grid, in the case where the calculation grid is decided as being the calculation grid that is partially contained, from among the calculation grids covering the building with the complex shape, and that performs the diffusion calculation.

**7.** A diffusion-state prediction method for predicting atmospheric conditions in a region of interest containing a point of interest, comprising:

a calculation-grid determining stage of determining a size of a calculation grid dividing a space in the region of interest;

a boundary-setting calculation stage of reading out, from among building shapes for the region of interest, a building shape of a high-rise building, which is a building higher than a length of one side of the calculation grid, setting the building shape in a boundary condition, and performing a diffusion calculation for the region of interest; and

a resistor calculating stage of defining, from among the building shapes for the region of interest, a plurality of low-rise buildings, which are buildings lower than or equal to the length of one side of the calculation grid, as a resistor group, reading out one or a plurality of calculation grids covering this resistor group as a low-rise calculation grid, determining a resistance coefficient on the basis of a space occupancy of this resistor group in the low-rise calculation grid, and performing the diffusion calculation for the region of interest.

**8.** A diffusion-state prediction program for predicting atmospheric conditions in a region of interest containing a point of interest, the diffusion-state prediction program causing a computer to execute:

a calculation-grid determining processing for determining a size of a calculation grid dividing a space in the region of interest;

a boundary-setting calculation processing for reading out, from among building shapes for the region of interest, a building shape of a high-rise building, which is a building higher than a length of one side of the calculation grid, setting the building shape in a boundary condition, and performing a diffusion calculation for the region of interest; and

a resistor calculation processing for defining, from among the building shapes for the region of interest, a plurality of low-rise buildings, which are buildings lower than or equal to the length of one side of the calculation grid, as a resistor group, reading out one or a plurality of calculation grids covering this resistor group as a low-rise calculation grid, determining a resistance coefficient on the basis of a space occupancy of the resistor group in the low-rise calculation grid, and performing the diffusion calculation for the region of interest.

**9.** A diffusion-state prediction method for predicting atmospheric conditions in a region of interest containing a point of interest, comprising:

a calculation-grid determining stage of dividing a space in the region of interest into a grid and determining a size of a calculation grid; and

a resistor calculating stage of performing a diffusion calculation for the region of interest on the basis of a resistance coefficient determined according to a space occupancy in the calculation grid,

wherein the resistor calculation stage, from among building shapes for the region of interest,

defines a plurality of low-rise buildings, which are buildings lower than or equal to a length of one side of the calculation grid, as a resistor group, reads out one or a plurality of calculation grids covering this resistor group as a low-rise calculation grid, determines a resistance coefficient on the basis of the space occupancy of the resistor group in the low-rise calculation grid, and performs a diffusion calculation for the region of interest; and reads out a building shape of a high-rise building, which is a building higher than the length of one side of the calculation grid, determines a resistance coefficient with the space occupancy in the building shape set at 100 percent, and performs the diffusion calculation for the region of interest.

**10.** A diffusion-state prediction program for predicting atmospheric conditions in a region of interest containing a point of interest, the diffusion-state prediction program causing a computer to execute:

a calculation-grid determining processing for determining a size of a calculation grid dividing a space in the region of interest; and

a resistor calculating processing for performing a diffusion calculation for the region of interest on the basis of a resistance coefficient determined according to a space occupancy in the calculation grid,

wherein the resistor calculation processing, from among building shapes for the region of interest,

defines a plurality of low-rise buildings, which are buildings lower than or equal to a length of one side of the calculation grid, as a resistor group, reads out one or a plurality of calculation grids covering this resistor group as a low-rise calculation grid, determines a resistance coefficient on the basis of the space occupancy of the resistor group in the low-rise calculation grid, and performs the diffusion calculation for the region of interest;

reads out a building shape of a high-rise building, which is a building higher than the length of one side of the calculation grid, determines a resistance coefficient with the space occupancy in the building shape set at 100 percent, and performs the diffusion calculation for the region of interest.

# FIG. 1

```
                           ┌──────────────┐
                           │     CPU      │───11
                           └──────┬───────┘
                                  ↕
                                  ║
        ┌──────────────┐          ║          ┌──────────────┐
   14───│    INPUT     │⟺       ⟺       ⟺│     MAIN     │───12
        │    DEVICE    │          ║          │   STORAGE    │
        └──────────────┘          ║          │    DEVICE    │
                                  ║          └──────────────┘
        ┌──────────────┐          ║          ┌──────────────┐
   15───│    OUTPUT    │⟺       ⟺       ⟺│  AUXILIARY   │───13
        │    DEVICE    │          ║          │   STORAGE    │
        └──────────────┘          ║          │    DEVICE    │
                                  ║          └──────────────┘
        ┌──────────────┐          ║
   16───│ COMMUNICATION│⟺       ⟺
        │    DEVICE    │          ║
        └──────────────┘          ║
                                  ⇕
```

# FIG. 2

REGION OF
INTEREST

EVALUATION
TIME

1

2

21

AIRFLOW DIFFUSION
CALCULATION UNIT

3

31

32

10

OUTPUT DIFFUSION
CALCULATION RESULTS

# FIG. 3

```
                    ┌─────────────┐
                    │    START    │
                    └──────┬──────┘
                           │
                           ▼
            ┌──────────────────────────────┐
            │  OBTAIN EVALUATION TIME AND   │────SA1
            │     REGION OF INTEREST        │
            └──────────────┬───────────────┘
                           │
                           ▼
            ┌──────────────────────────────┐
            │     DETERMINE SMALLEST        │────SA2
            │     CALCULATION GRID          │
            └──────────────┬───────────────┘
                           │
                           ▼
            ┌──────────────────────────────┐
            │   DETERMINE CALCULATION GRID  │────SA3
            └──────────────┬───────────────┘
                           │
                           ▼
                      ╱─────────╲   SA4
                    ╱   COMPARE    ╲
                  ╱  CALCULATION GRID ╲
                 ╱  WITH BUILDING       ╲   NO
                ╲  INFORMATION.         ╱────────┐
                 ╲ LOW-RISE BUILDING   ╱         │
                   ╲       ?         ╱           │
                     ╲─────────────╱             │
                        │ YES                    │
                        │                        │  SA5
                        ▼                        ▼
        ┌──────────────────────┐    ┌──────────────────────┐
  SA6───│  AIRFLOW DIFFUSION    │    │  AIRFLOW DIFFUSION    │
        │   CALCULATION         │    │   CALCULATION         │
        │ USING CANOPY MODEL    │    │  USING CFD MODEL      │
        └──────────┬───────────┘    └──────────┬───────────┘
                   │◄──────────────────────────┘
                   │
                   ▼
        ┌──────────────────────┐
        │ OUTPUT RESULTS OF     │────SA7
        │ AIRFLOW DIFFUSION     │
        │    CALCULATION        │
        └──────────┬───────────┘
                   │
                   ▼
            ┌─────────────┐
            │     END     │
            └─────────────┘
```

15

FIG. 4

# FIG. 5

REGION OF
INTEREST

EVALUATION
TIME

AIRFLOW DIFFUSION
CALCULATION UNIT

1

2

21

3″

31

32

33

34

35

10″

OUTPUT DIFFUSION
CALCULATION RESULTS

FIG. 6

FIG. 7

FIG. 8

| | |
|---|---|
| **INTERNATIONAL SEARCH REPORT** | International application No.<br>PCT/JP2010/068022 |

**A. CLASSIFICATION OF SUBJECT MATTER**
*G06F19/00*(2011.01)i, *G01W1/00*(2006.01)i

According to International Patent Classification (IPC) or to both national classification and IPC

**B. FIELDS SEARCHED**

Minimum documentation searched (classification system followed by classification symbols)
G06F19/00, G01W1/00

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)
JSTPlus(JDreamII), JST7580(JDreamII)

**C. DOCUMENTS CONSIDERED TO BE RELEVANT**

| Category* | Citation of document, with indication, where appropriate, of the relevant passages | Relevant to claim No. |
|---|---|---|
| X | JP 2008-089418 A (Mitsubishi Heavy Industries, Ltd.), <br>17 April 2008 (17.04.2008), <br>paragraphs [0045] to [0050] <br>(Family: none) | 1-10 |
| A | JP 2002-049298 A (Obayashi Corp.), <br>15 February 2002 (15.02.2002), <br>claim 10; paragraphs [0124], [0144] <br>(Family: none) | 1-10 |
| A | Hidetoshi TAMURA, "Development of numerical model for predicting urban thermal environment around buildings. (No. 2). Numerical simulation in Tokyo 23 wards", Denryoku Chuo Kenkyusho Hokoku, 1999.12, U99022 | 1-10 |

☐ Further documents are listed in the continuation of Box C.   ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search <br> 14 December, 2010 (14.12.10) | Date of mailing of the international search report <br> 28 December, 2010 (28.12.10) |
|---|---|
| Name and mailing address of the ISA/ <br> Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002202383 A

**Non-patent literature cited in the description**

- Guidebook for Practical Applications of CFD to Pedestrian Wind Environment around Buildings. Showa Joho Process Co., Ltd, 20 July 2007, 49-51